# EUROPÄISCHE PATENTSCHRIFT

(11) **EP 1 095 401 B1**
(45) Veröffentlichungstag und Bekanntmachung des Hinweises auf die Patenterteilung: **14.11.2007**
(21) Anmeldenummer: 00931030.1
(22) Anmeldetag: 26.04.2000
(51) Int. Cl.: H01L 21/3065, H01L 21/66

(54) **VERFAHREN ZUM ANISOTROPEN PLASMAÄTZEN VON HALBLEITERN**
METHOD FOR ANISOTROPIC PLASMA ETCHING OF SEMICONDUCTORS
PROCEDE DE GRAVURE AU PLASMA ANISOTROPE DE SEMI-CONDUCTEURS

(30) Priorität: 30.04.1999 DE 19919832
(43) Veröffentlichungstag der Anmeldung: 02.05.2001
(73) Patentinhaber: ROBERT BOSCH GMBH, 70442 Stuttgart (DE)
(72) Erfinder: LAERMER, Franz, D-70437 Stuttgart (DE); SCHILP, Andrea, D-73525 Schwaebisch Gmuend (DE)
(86) Internationale Anmeldenummer: PCT/DE2000/001296
(87) Internationale Veröffentlichungsnummer: WO 2000/067306

(56) Entgegenhaltungen:
- EP-A- 0 383 570
- EP-A- 0 822 582
- DE-C- 4 241 045
- DE-C- 19 730 644
- US-A- 5 458 732
- US-A- 5 770 097

## Beschreibung

Die Erfindung betrifft ein Verfahren zum anisotropen Ätzen von Strukturen in einem Halbleiterkörper, insbesondere von mit einer Ätzmaske lateral exakt definierten Ausnehmungen in einem Siliziumkörper, mittels eines Plasmas nach der Gattung des Hauptanspruches.

### Stand der Technik

Aus DE 42 41 045 C1 ist ein Verfahren zum anisotropen Plasmaätzen von Silizium bekannt. Dabei wechseln sich sogenannte Passivier- und Ätzschritte einander ab, wobei während der Passivierschritte Polymermaterial auf den freigeätzten Strukturen abgeschieden wird und während der Ätzschritte Fluorradikale aus einem Fluorlieferanten im Plasma freigesetzt werden, welche Silizium an sich isotrop ätzen. Durch einen gerichteten Ioneneinfall während der Ätzschritte, der den Ätzgrund der geätzten Strukturen bombardiert, wird weiter zu Beginn eines jeden Ätzschrittes zunächst ein Durchbruch des im vorausgehenden Passivierschritt erzeugten Ätzgrundpolymers vollzogen.

Während der an sich isotropen Ätzschritte wird weiter eine lokale Anisotropie dadurch erreicht, daß der Anteil der schräg einfallenden Ionen, welche die Seitenwand der Strukturen treffen, ein Vorwärtssputtern, d.h. einen Abtrag und eine Redeposition des Seitenwandpolymerfilms hin zu tieferen Teilen des erzeugten Trenchgrabens während der Ätzung bewirken, so daß beim Weiterätzen die Seitenwände stets von einem Schutzfilm passiviert bleiben und vor dem Ätzangriff der isotrop agierenden Fluorchemie geschützt sind.

Insgesamt muß dazu die während der Ätzschritte benötigte Ionenenergie, die über eine durch Hochfrequenzleistungseinspeisung erzeugte Beschleunigungsspannung an der Substratelektrode bzw. dem zu ätzenden Siliziumwafer hervorgerufen wird, ausreichen, um einen Durchbruch der Ätzgrundpassivierung zu Beginn eines jeden Ätzschrittes zu gewährleisten, und daneben den Ätzgrund während der Ätzschrittes von Polymer freizuhalten und den Seitenwandpolymerfilmtransportmechanismus aufrechtzuerhalten. Dies wird in DE 42 41 045 C1 durch eine relativ niedrige Ionenenergie von 10 bis 50 eV erreicht, die während der gesamten Dauer der Ätzschritte angelegt wird.

Infolge der konstanten Ionenbeschleunigung ergibt sich weiter eine feste Selektivität zwischen dem Seitenwandfilmabtrag und dem Abtrag des Ätzgrundpolymers, wobei die Dauer eines jeden Ätzschrittes weiter dadurch limitiert ist, daß der Großteil des Seitenwandpolymerfilms während der Ätzschritte abgetragen, d.h. vorwärtsgesputtert worden ist. Dieser muß daher durch einen erneuten Passivierschritt regelmäßig reinstalliert werden, was letztlich auch die erreichbaren Ätzraten beschränkt, da die Passivierpausen eine Unterbrechung des Ätzfortschrittes darstellen. Wird mit zuwenig Passivierung prozessiert, leidet im übrigen die Anisotropie der Ätzung und es kommt im Bereich dielektrischer Grenzflächen d.h. beispielsweise beim Ätzstopp der Siliziumätzung auf einer Ätzstoppschicht, zur Ausbildung von lateralen Taschen, dem sogenannten "Notching-Phänomen".

Im Dokument DE 198 41 964.3 ist bereits vorgeschlagen worden, eine Plasmaätzanlage mit einer Vorrichtung zur Kühlung eines Siliziumkörpers während eines anisotropen Ätzprozesses zu versehen. Schließlich ist aus DE 197 30 644.9 bereits bekannt, die Konzentration von Fluoratomen oder -ionen in einem Plasma mittels eines optischen Emissionspektrometers und einer nachgeschalteten Auswerteeinheit zu bestimmen.

EP 822582 und EP 383570 offenbaren Verfahren zum anisotropen Plasmaätzen von Strukturen in einem Halbleiterkörper.

### Vorteile der Erfindung

Das erfindungsgemäße Verfahren mit den kennzeichnenden Merkmalen des Hauptanspruches hat gegenüber dem Stand der Technik den Vorteil, daß damit eine Anpassung der Intensität der effektiven Ionenbeschleunigung zwischen Plasma und Substratelektrode an die physikalisch-chemischen Abläufe während der Ätzschritte und bei Bedarf auch während der Polymerisationsschritte ermöglicht wird, so daß der Seitenwandpolymerfilm dem Ätzschritt länger standhalten kann. Dies hat zur Folge, daß in den Ätzschritten länger geätzt werden kann und die Unterbrechungen durch Passivierschritte seltener werden, d.h. erst in größeren Zeitabständen erforderlich sind. Somit wird vorteilhaft eine insgesamt höhere Ätzrate erreicht.

Vorteilhafte Weiterbildungen der Erfindung ergeben sich aus den in den Unteransprüchen genannten Maßnahmen.

So wird vorteilhaft die Maskenselektivität dadurch verbessert, daß nur in den initialen Ätzgrundpolymerdurchbruchphasen mit hoher Ionenbeschleunigungsspannung geätzt wird, während über die restliche Dauer der Ätzschritte mit einer über eine reduzierte Spannung erzeugten reduzierten Ionenbeschleunigung nur noch der Ätzgrund von Polymermaterial freigehalten und der Seitenwandfilmtransportmechanismus aufrechterhalten werden muß.

Schließlich wird auch die Anisotropie des Ätzprozesses, insbesondere hinsichtlich des erzielten vertikalen Profils, verbessert, da die Passivierung der Seitenwände effektiver ist und die Prozeßparameter so optimiert werden können, daß die jeweils exakt richtige Polymermenge abgetragen und redeponiert, also durch den über die anliegende Spannung induzierten Ioneneinfall vorwärtsgesputtert wird.

Vorteilhaft ist weiterhin, daß durch eine während der Ätzschritte zeitweilig verminderte hochfrequente Wechselspannung oder eingekoppelte Hochfrequenzleistung, die mit einer verminderten Ionenbeschleunigungsspannung verbunden ist, das Seitenwandpolymer langsamer abgetragen wird, so daß eine bessere Selektivität des Ätzgrundpolymerabtrags relativ zum Seitenwandpolymerabtrag über einen Ätzschritt hinweg erreicht wird. Infolgedessen können die Ätzschritte sehr vorteilhaft zeitlich verlängert werden, was die Ätzrate und gleichzeitig auch die Anisotropie der Ätzung verbessert. Dies beruht darauf, daß in den Ätzschritten jeweils genau soviel Polymer vorwärtsgesputtert wird, wie zum Erzielen eines optimalen Ätzprofils (senkrechte Wände) benötigt wird. Gleichzeitig wird bei verminderter Ionenbeschleunigung auch weniger Maskenmaterial abgetragen, so daß damit vorteilhaft auch eine höhere Maskenselektivität erreicht wird.

Schließlich ist das erfindungsgemäße Verfahren insgesamt auch "sanfter", d.h. weniger aggressiv bei Erreichen einer dielektrischen Grenzfläche, da die Ionenenergie nach dem Durchbruch der Ätzgrundpassivierung jedesmal reduziert wird. Somit werden schädliche Auswirkungen der Ionenbombardierung, insbesondere der "Notching-Effekt" mit Taschenbildung infolge von elektrischen Aufladungen und Ionenablenkung in Grenzflächenbereichen, über die verbleibende Zeit des Ätzschrittes reduziert.

Vorteilhaft ist weiterhin, daß durch ein optisches Emissionsspektrometer, das die Fluorkonzentration in dem Plasma als Funktion der Zeit bestimmt, die Dauer der Ätzabschnitte dynamisch kontrolliert und über den Hochfrequenzgenerator geregelt werden kann.

Das erfindungsgemäße Verfahren erlaubt es weiterhin vorteilhaft, zwischen den Ätzabschnitten und beim Übergang von Ätzschritten zu den Polymerisationsschritten die eingekoppelte Hochfrequenzleistung kontinuierlich mit einer Rampenfunktion zu verändern.

Darüberhinaus ist vorteilhaft, daß das erfindungsgemäße Verfahren mit einer Vielzahl von weiteren Prozeßparametern verknüpft und an die jeweiligen Erfordernisse optimiert werden kann. Dazu eignet sich beispielsweise der Prozeßdruck, der Gasfluß der zugeführten Reaktivgase und die Plasmaleistung.

Besonders vorteilhaft ist weiterhin, wenn die zeitliche Veränderung der Ionenbeschleunigungsspannung mit einer Anpassung der Temperatur des zu ätzenden Siliziumkörpers verknüpft ist. Damit läßt sich ein nahezu gleichzeitiger Durchbruch des Ätzgrundpolymers unabhängig von den Aspektverhältnissen der jeweiligen Trenchgräben erreichen.

Zur Veränderung der Ionenbeschleunigungsspannung besteht vorteilhaft eine Vielzahl von Möglichkeiten. Bevorzugt ist eine Modulation der eingekoppelten Hochfrequenzleistung mit einer niederfrequenten Modulationsspannung während der Ätzabschnitte oder die Aufteilung der anliegenden Hochfrequenzleistung bzw. hochfrequenten Wechselspannung in Wechselspannungspulse mit definiert einstellbarem Impuls-Pause-Verhältnis, das in einer besonders vorteilhaften Ausgestaltung deutlich kleiner als 1 gewählt wird. Hierdurch lassen sich elektrische Aufladungen, die sogenannte "Notching"-Effekte bewirken können, reduzieren.

Die Ionenbeschleunigungsspannung wird in diesem Fall in Form zeitlich sehr kurzer, sehr intensiver Hochfrequenzimpulse mit relativ langen Pausen zwischen den Pulsen bewirkt, wobei der Durchschnittswert der Ionenbeschleunigung unmittelbar über das Impuls-Pause-Verhältnis in einem weiten Bereich einstellbar wird.

Zur Beschleunigung des initialen Ätzgrundpolymerdurchbruchs zu Beginn eines Ätzschrittes ist es weiter vorteilhaft, wenn in dieser Zeit dem Prozeßgas ein chemisch gegenüber dem Ätzgrundpolymer besonders aggressives Gas wie NF₃ oder O₂ zugesetzt wird.

### Zeichnung

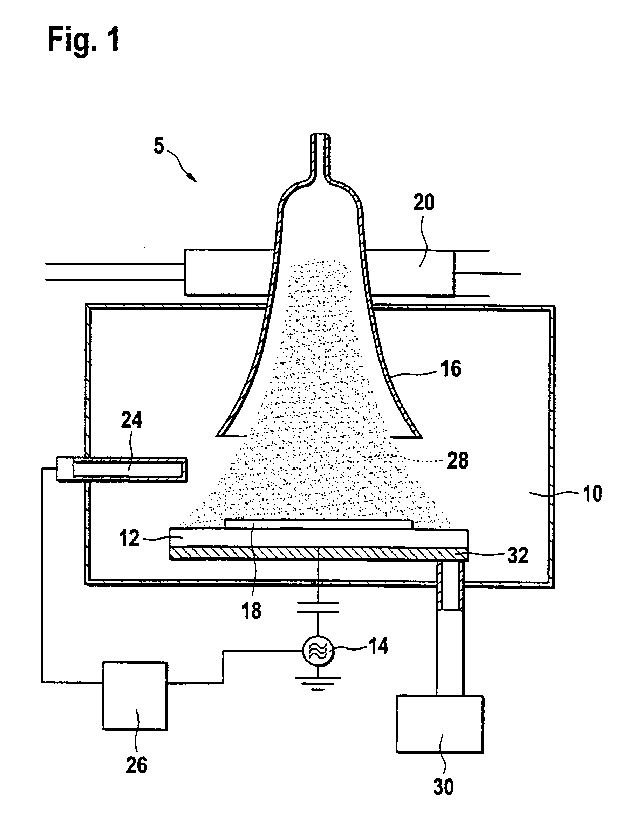

Die Erfindung wird anhand der Zeichnung und in der nachfolgenden Beschreibung näher erläutert. Die Figur zeigt eine Plasmaätzanlage.

### Ausführungsbeispiele

Die Figur zeigt eine Plasmaätzanlage 5 mit einer Ätzkammer 10 in der eine Substratelektrode 12 angeordnet ist, die mit einem zu ätzenden Siliziumkörper 18, insbesondere einem mit einer Ätzmaske strukturierten Siliziumwafer, in Kontakt ist. Weiter ist ein Hochfrequenzgenerator 14 vorgesehen, der eine Hochfrequenzleistung erzeugt, die über die Substratelektrode 12 in den Siliziumkörper 18 eingekoppelt wird. Somit liegt an dem Siliziumkörper 18 über die eingekoppelte Hochfrequenzleistung eine hochfrequente Wechselspannung an. Diese bewirkt als Ionenbeschleunigungsspannung eine Beschleunigung von positiv geladenen, in einem Plasma 28 generierten Ionen, die damit zumindest weitgehend nahezu senkrecht auf die Oberfläche des Siliziumkörpers 18 einfallen. Weiter ist ein Surfatron 16 und ein Hohlleiter 20 vorgesehen. Der Hohlleiter 20 dient zur Einstrahlung oder Einkopplung elektrischer Felder an das Surfatron 16 zur Erzeugung des Plasmas 28, insbesondere elektrischer Hochfrequenzfelder oder bevorzugt elektrischer Mikrowellenfelder. Dem Surfatron 16 werden von oben weiter in an sich bekannter Weise Reaktivgase zugeführt.

Zur Analyse der Zusammensetzung des Plasmas 28 als Funktion der Zeit anhand für die Plasmazusammensetzung typischer Emissionslinien ist weiter ein optisches Emissionsspektrometer 24 vorgesehen, das mit einer Auswerteeinheit 26 in Verbindung steht. Die Auswerteeinheit 26 ist dabei weiter mit einem Sollwerteingang des Hochfrequenzgenerators 14 verbunden, so daß die von dem Hochfrequenzgenerator 14 in den Siliziumkörper 18 eingekoppelte hochfrequente Wechselspannung, die die Ionenbombardierung aus dem Plasma 28 bewirkt, über die Auswerteeinheit 26 als Funktion der über das optische Emissionsspektrometer bestimmten Plasmazusammensetzung geregelt wird. Weiter ist ein Kühlaggregat 30 vorgesehen, das mit einer Substratelektrodenkühlung 32 in Verbindung steht, und über das eine Temperatureinstellung der Substratelektrode 12 und darüber des Siliziumkörpers 18 im Bereich von -30°C bis +70°C einstellbar ist. Die vom Hochfrequenzgenerator 14 in die Substratelektrode eingekoppelte Hochfrequenzleistung bzw. hochfrequente Wechselspannung kann einerseits eine zeitlich während eines Ätzschrittes in ihrer Amplitude konstante Hochfrequenzleistung oder hochfrequente Wechselspannung sein, sie kann jedoch in bevorzugter Ausgestaltung auch eine getaktete Hochfrequenzleistung bzw. hochfrequente Wechselspannung mit variabel zwischen den Ätzschritten und/oder während eines Ätzschrittes einstellbarem Puls-Pause-Verhältnis sein, wobei die Pulse besonders bevorzugt sehr kurz und intensiv und die Pausen zwischen den Pulsen relativ lang gewählt werden.

Die Plasmaätzanlage 5 und ein damit durchführbares anisotropes Plasmaätzverfahren ist grundsätzlich, abgesehen von dem vorgesehenen Emissionsspektrometer 24, der Auswerteeinheit 26 sowie der darüber geregelten hochfrequenten Wechselspannung bzw. Hochfrequenzleistung an dem Siliziumkörper 18, und der Substratelektrodenkühlung 32, aus DE 42 41 045 C1 bekannt.

Eine Plasmaätzanlage mit einer Vorrichtung zur Kühlung eines Siliziumkörpers während eines anisotropen Ätzprozesses ist weiter in der unveröffentlichten Anmeldung DE 198 41 964.3 bereits vorgeschlagen worden. Aus dieser Anmeldung sind auch weitere Details zur technischen Realisierung der Substratelektrodenkühlung 32 und dem Kühlaggregat 30 zu entnehmen.

Kern der Erfindung ist die gezielte und kontrollierte Modulation der an dem Siliziumkörper 18 effektiv anliegenden Ionenbeschleunigungsspannung über die Zeitdauer der Ätzschritte.

Dazu werden die Ätzschritte jeweils in mindestens zwei Ätzabschnitte unterteilt, wobei in den einzelnen Ätzabschnitten mit gegenüber dem vorausgehenden Ätzabschnitt unterschiedlicher hochfrequenter Wechselspannung oder Hochfrequenzleistung und somit unterschiedlicher effektiver Ionenbeschleunigung von elektrisch geladenen Teilchen zum Siliziumkörper 18 aus dem Plasma 28 gearbeitet wird.

Die unterschiedlichen Ionenbeschleunigungsspannungen an dem Siliziumkörper 18 werden dazu zumindest zeitweise bevorzugt über entsprechende, unterschiedliche eingekoppelte Hochfrequenzleistungen des Hochfrequenzgenerators 14 erzeugt.

Im einzelnen wird als erstes Ausführungsbeispiel zu Beginn eines jeden Ätzschrittes über den Hochfrequenzgenerator 14 zunächst eine Hochfrequenzleistung oder eine hochfrequente Wechselspannung über die Substratelektrode 12 an den Siliziumkörper 18 angelegt, welche zum raschen Durchbruch eines während eines vorausgehenden Passivier- oder Polymerisationsschrittes erzeugten Ätzgrundpolymers, beispielsweise in bereits geätzten Trenchgräben, ausreichend ist. Nachdem das Ätzgrundpolymer in diesem ersten Ätzabschnitt durchbrochen worden ist, wird dann beispielsweise die Hochfrequenzleistung so weit reduziert, daß einerseits eine erneute Bedeckung des Ätzgrundes mit Polymermaterial verhindert wird, daß diese andererseits aber noch ausreichend ist zur Aufrechterhaltung des bekannten Seitenwandpolymerfilmtransports, der seinerseits zur Bewahrung der lokalen Anisotropie des Plasmaätzverfahrens in den Ätzschritten notwendig ist.

Ausgehend von einem anisotropen Plasmaätzverfahren für Silizium, wie es beispielsweise aus DE 42 41 045 C1 bekannt ist, ist ein für das erfindungsgemäße Verfahren geeigneter Parametersatz dann durch folgende Einstellungen für die verwendeten Gase, Gasflüsse, Plasmaleitungen, Plasmaleistungen, Dauer der einzelnen Verfahrensschritte und der Größe der eingekoppelten Hochfrequenzleistung bzw. anliegenden hochfrequenten Wechselspannung gegeben:
Passivier- oder Polymerisationsschritt:
   100 sccm C₄F₈ bei 10 µbar Druck, 800 Watt Plasmaleistung, 5 Sekunden Dauer des Passivierschritts, keine Hochfrequenzleistung am Siliziumkörper 18 oder der Substratelektrode 12
Ätzschritt:
   Gesamtdauer eines Ätzschrittes: 20 Sekunden
erster Ätzabschnitt des Ätzschrittes:
   130 sccm SF₆ + 20 sccm O₂ bei 20 µbar Druck, 800 Watt Plasmaleistung, Hochfrequenzleistung von 10 Watt oder Amplitude der hochfrequenten Wechselspannung (13,56 MHz) von 30 bis 50 Volt, Dauer des ersten Ätzabschnittes: 2 Sekunden (Durchbruchsphase des Ätzgrundpolymers)
zweiter Ätzabschnitt des Ätzschrittes:
   130 sccm SF₆ + 20 sccm O₂ bei 20 µbar Druck, 800 Watt Plasmaleistung, Hochfrequenzleistung von 4 Watt oder Amplitude der hochfrequente Wechselspannung (13,56 MHz) von 10 bis 20 Volt, Dauer des zweiten Ätzabschnittes: 18 Sekunden (Freihalten des Ätzgrundes von Polymermaterial sowie Vorwärtstreiben des Seitenwandpolymerfilms)

Der genannte Parametersatz ist dabei nur als Beispiel zu verstehen. Geeignete Werte für die Amplitude der hochfrequenten Wechselspannung und der über diese im erläuterten Beispiel vorgegebenen effektiven Ionenbeschleunigungsspannung liegen üblicherweise zwischen 1 Volt und 100 Volt bei einer Frequenz von 1 MHz bis 50 MHz.

In diesem ersten Ausführungsbeispiel wird zunächst die Hochfrequenzleistung innerhalb eines Ätzabschnittes in ihrer Amplitude zeitlich nicht verändert d.h. der Hochfrequenzgenerator 14 wird innerhalb der Ätzabschnitte kontinuierlich bei konstanter Hochfrequenzleistung betrieben und koppelt damit eine zeitlich in ihrer Amplitude innerhalb der Ätzabschnitte konstante hochfrequente Wechselspannung in die Substratelektrode 12 ein.

Die Aufteilung des Ätzschrittes in eine erste, kurze Phase von 2 Sekunden mit einer relativ hohen Spannungsamplitude an der Substratelektrode 12 oder dem Siliziumkörper 18 und eine zweite, lange Phase von 18 Sekunden mit einer relativ niedrigen Spannungsamplitude ergibt sich dabei aus der Beobachtung, daß nach ca. 2 Sekunden unter den angegebenen Bedingungen ein vollständiger Durchbruch des Ätzgrundpolymers erfolgt ist, und daß danach nur noch mit reduzierter effektiver Ionenbeschleunigungsspannung zwischen Plasma 28 und Substratelektrode 12 der Seitenwandfilmtransport sowie die Unterdrückung der Redeposition auf dem Ätzgrund aufrechterhalten werden muß.

Eine vorteilhafte Weiterführung des erläuterten ersten Ausführungsbeispiels ergibt sich dadurch, daß die Plasmaätzanlage 5 weiterhin eine Vorrichtung aufweist, mit dem sich der Zeitpunkt des Durchbruches des Ätzgrundpolymers meßtechnisch anhand einer physikalischen Meßgröße genau detektieren läßt, so daß die Zeitdauer der einzelnen Ätzabschnitte mit dieser Vorrichtung während des jeweiligen Ätzschrittes erfaßt und dynamisch geregelt werden kann.

Als eine derartige Vorrichtung ist beispielsweise das optische Emissionsspektrometer 24 zur Plasmadiagnose geeignet. Dazu wird dieses beispielsweise auf eine Fluoremissionslinie, beispielsweise auf 687 nm oder 704 nm, eingestellt, so daß die Intensität der Fluoremission im Plasma 28 indirekt das Angebot an fluorverzehrender offener Siliziumfläche anzeigt. Je höher die offene Siliziumfläche als Funktion der Zeit ist, desto niedriger ist die gemessenen Fluorintensität, da in diesem Zeitraum viel Fluor aus dem Plasma 28 für Ätzreaktionen verbraucht wird. Je niedriger die offene Siliziumfläche, desto höher ist entsprechend die Fluorintensität. Solange der Siliziumätzgrund der geätzten Strukturen des Siliziumkörpers 18 polymerbedeckt ist, ist die offene Siliziumfläche praktisch Null. Im Fall des Durchbruches des Ätzgrundpolymers wirkt dann aber mehr oder weniger die volle freigeätzte Siliziumoberfläche als Fluorverbraucher.

Hinsichtlich weiterer, an sich bekannter Details der Bestimmung der Fluorkonzentration mittels des optischen Emissionspektrometers 24 und der nachgeschalteten Auswerteeinheit 26 im Plasma 28 bzw. zur Detektion des exakten Zeitpunktes des Durchbruchs des Ätzgrundpolymers sei auf die Anmeldung DE 197 30 644.9 verwiesen.

Im erläuterten Beispiel kann somit mittels des optischen Emissionsspektrometers 24 die Zeitdauer des ersten Ätzabschnittes bzw. des Durchbruchs des Ätzgrundpolymers entweder einmal für den jeweiligen Prozeß festgestellt und dann fest in die Auswerteeinheit 26 einprogrammiert werden, so daß diese dann zu den entsprechenden Zeiten die Hochfrequenzleistung des Hochfrequenzgenerators 14 entsprechend einstellt, und sich somit die dem jeweiligen Ätzabschnitt zugeordnete hochfrequente Wechselspannung bzw. effektive Ionenbeschleunigungsspannung am Siliziumkörper 18 einstellt. Alternativ und bevorzugt ist jedoch eine dynamische Regelung vorgesehen, wobei aus dem Signal des optischen Emissionsspektrometers 24 der Intensitätsverlauf der Fluoremission detektiert wird und über die Auswerteeinheit 26 bevorzugt kontinuierlich einem Ätzabschnitt zugeordnet wird. Die Auswerteeinheit 26 regelt somit durch Zusammenwirken mit dem Hochfrequenzgenerator 14 und dem optischen Emissionsspektrometer 24 die eingekoppelte Hochfrequenzleistung oder die dem jeweiligen detektierten Ätzabschnitt zugeordnete hochfrequente Wechselspannung auf voreingestellte Sollwerte.

Somit ist in einfacher Weise ein Parametersatz für die Zeitdauer der einzelnen, bevorzugt zwei, Ätzabschnitte während eines Ätzschrittes ermittelbar, der im übrigen auch dynamisch von dem beispielhaft angegebenen Parametersatz während eines Ätzschrittes oder eines Ätzabschnittes abweichen kann. Daher sind Vorversuche zur Ermittlung des optimalen Zeitpunktes für die Reduktion der Hochfrequenzleistung bzw. der effektiven Ionenbeschleunigungsspannung während eines Ätzschritte nicht mehr erforderlich.

Alternativ zur optischen Emissionsspektroskopie zur Erkennung des Ätzgrundpolymerdurchbruchs bzw. des Zeitpunktes des Übergangs zwischen zwei Ätzabschnitten kann sowohl bei dynamischer Bestimmung mit nachgeschalteter Regelung als auch im Fall einer statischen Bestimmung mit nachgeschalteter Steuerung auch die Laserinterferometrie bzw. Reflektometrie eingesetzt werden. Beide Verfahren sind im Stand der Technik als Endpunkterkennungssysteme allgemein bekannt.

Mit den genannten Vorrichtungen zur Detektion des Ätzgrundpolymerdurchbruchs ist es weiter problemlos möglich zu detektieren, ob die in einem zweiten Ätzabschnitt nach dem Durchbruch eingesetzte Hochfrequenzleistung oder an der Substratelektrode 12 anliegende hochfrequente Wechselspannung im Verlauf des zweiten Ätzabschnittes stets ausreichend ist, um den Ätzgrund der herausgeätzten Struktur frei von Polymermaterial zu halten.

Reicht diese Spannung dazu zeitweilig nicht aus, äußert sich dies sofort in einer Redeposition von Polymermaterial auf dem Ätzgrund, was zu einer Signalveränderung im optischen Emissionsspektrometer 24 führt, die im Fall einer dynamischen Regelung mit der Verarbeitungseinheit 26 über eine Erhöhung der am Siliziumkörper 18 über den Hochfrequenzgenerator 14 anliegenden Wechselspannung sofort kompensiert wird.

Für die Größe der eingekoppelten Hochfrequenzleistung oder die Amplitude der hochfrequenten Wechselspannung in dem zweiten Ätzabschnitt nach Durchbruch des Ätzgrundpolymers gilt dabei allgemein: Sowenig wie möglich, soviel wie nötig. Eine zu geringe Spannung hat eine unbefriedigende Anisotropie zur Folge, während eine zu hohe Spannung einen Verlust an Maskenselektivität, Ätzrate und Anisotropie bedeutet und eine vermehrte Taschenbildung fördert.

Es sei im übrigen betont, daß das Zurückschalten der Hochfrequenzleistung oder der am Siliziumkörper 18 anliegenden hochfrequenten Wechselspannung nicht schlagartig erfolgen muß, sondern auch über eine zeitliche Rampenfunktion, beispielsweise über eine Zeit von 0,5 Sec bis 4 sec erfolgen kann. Dabei wird nach dem ersten Ätzabschnitt die Hochfrequenzspannung beispielsweise über eine Zeit von 2 Sekunden reduziert, nach der sie dann den Sollwert des zweiten Ätzabschnittes erreicht und auf diesem gehalten wird.

Ein zweites Ausführungsbeispiel der Erfindung sieht vor, daß in Weiterführung des ersten Ausführungsbeispiels in den Passivier- oder Polymerisationsschritten anstelle mit 800 Watt mit relativ hohen Plasmaleistungen von beispielsweise 1500 Watt gearbeitet wird, wobei der Prozeßdruck vorzugsweise im für Passivierung optimalen Druckbereich von 10 µbar bis 20 µbar und der Gasfluß bei 100 sccm bis 200 sccm liegt.

Damit wird erreicht, daß in den Passivierschritten ein besonders widerstandsfähiges, relativ dickes Seitenwandpolymer abgeschieden wird, das im nachfolgenden Ätzschritt aufgrund seiner durch erhöhte Dichte verbesserten chemischen Resistenz besonders stabil hält.

Zusätzlich wird in diesem Ausführungsbeispiel über den Hochfrequenzgenerator 14 auch während der Passivierschritte bereits eine zusätzliche Ionenbeschleunigung durch Anlegen einer Hochfrequenzspannung von beispielsweise 5 Volt bis 20 Volt bzw. einer Hochfrequenzleistung von 2 Watt bis 5 Watt eingesetzt, um bereits während der Passivierschritte einen Transport des abgeschiedenen Seitenwandpolymermaterials in die Tiefe der erzeugten Trenchgräben zu bewirken. Damit werden auch die tieferliegenden Teile der Trenchgräben besonders effektiv mit einem Seitenwandschutzfilm bedeckt, wobei gleichzeitig die Dicke des erzeugten Seitenwandfilms in den oberen Bereichen der Trenchgräben dünner ist als ohne Ionenbeschleunigung und die Dicke des Seitenwandfilms im unteren Teil des Trenchgrabens zunimmt.

Je nachdem, ob die Priorität im erläuterten Ausführungsbeispiel auf der Unterdrückung von sogenannten "Notching-Effekten" d.h. einer unerwünschten Unterätzung oder Profilabweichung an dielektrischen Grenzflächen im zu ätzenden Siliziumkörper 18 oder im Erreichen möglichst hoher Ätzraten beim Ätzprozeß liegt, wird dann auf unterschiedliche Weise in den Ätzschritten weiterverfahren.

Liegt die Priorität auf der Vermeidung von "Notching-Effekten" an dielektrischen Grenzflächen, wird der nachfolgende Ätzschritt relativ schonend durchgeführt d.h. die Plasmaleistung verbleibt beispielsweise auf einem relativ niedrigen Wert von 800 Watt oder wird sogar auf beispielsweise 600 Watt reduziert. Dadurch wird die Ionendichte im Plasma 28 insgesamt niedrig gehalten und der Ätzschritt ist wenig aggressiv. Zur weiteren Minimierung von elektrischen Aufladungseffekte wird dazu gleichzeitig auch der Prozeßdruck im Ätzschritt bevorzugt auf 25 µbar bis 40 µbar erhöht.

Nach einem kurzen, sehr intensiven ersten Ätzabschnitt des Ätzschrittes analog dem ersten Ausführungsbeispiel wird dann mit dem Durchbruch des nunmehr sehr widerstandsfähigen Ätzgrundpolymers in einen schonenden, zweiten Ätzabschnitt ebenfalls gemäß dem ersten Ausführungsbeispiel umgeschaltet, wo dank des nunmehr widerstandsfähigen Seitenwandpolymers eine sehr wirksame Passivierung der Strukturseitenwand jedes "Notching" d.h. Profilabweichungen verhindert.

Dabei wird bevorzugt in dem zweiten Ätzabschnitt zusätzlich der Prozeßdruck der Reaktivgase in der Plasmaätzanlage 5 beispielsweise auf 25 µbar bis 40 µbar nach dem Durchbruch des Ätzgrundpolymers erhöht und damit die Ionendichte, der Ionenfluß und Aufladungseffekte im zweiten Ätzabschnitt nachhaltig reduziert.

Liegt die Priorität dagegen auf der Erzielung einer möglichst hohen Ätzrate, wird zum Erreichen einer möglichst hohen Dichte Silizium ätzender Fluorradikale eine möglichst hohe Leistung in den Ätzzyklen eingesetzt. Dazu wird die Plasmaleistung im Ätzschritt über die Leistung im Passivierschritt hinaus auf Werte von 3000 Watt bis 5000 Watt erhöht, wobei bevorzugt mit einem möglichst hohen Prozeßdruck von beispielsweise 40 µbar bis 100 µbar die Dichte freier Fluorradikale weiter gesteigert wird. Dieser hohe Prozeßdruck bewirkt zusätzlich eine Absenkung der Ionendichte im Ätzschritt, was durch Reduktion des Ionenstroms zum Siliziumkörper 18 schädliche Aufladungseffekte vermindert und damit die Profilkontrolle verbessert.

Insgesamt wird ansonsten auch in dieser Verfahrensvariante zunächst entsprechend dem ersten Ausführungsbeispiel in einem kurzen, aggressiven ersten Ätzabschnitt des Ätzschrittes der Ätzgrund von zuvor deponiertem Polymermaterial befreit, während der nachfolgenden Ätzabschnitt die beschriebene, bezüglich des Seitenwandpolymermaterials schonendere Prozeßführung beinhaltet. Durch die Abscheidung eines besonders robusten Seitenwandpolymermaterials während des Passivierschrittes hält dieses dabei dem fluorreichen Ätzschritt besonders gut stand, so daß entsprechend tief und mit hoher Rate geätzt werden kann.

Ein drittes Ausführungsbeispiel der Erfindung sieht, in Weiterführung des ersten oder zweiten Ausführungsbeispiels zusätzlich vor, den Durchbruch durch das Ätzgrundpolymer in allen Trenchgräben unabhängig von deren Breite oder Tiefe zu Breite-Verhältnis (Aspektverhältnis) durch gezielte Einstellung der Temperatur des Siliziumkörpers 18 in etwa gleichzeitig ablaufen zu lassen.

Im allgemeinen ist die Polymerabtragsgeschwindigkeit in schmalen Trenchgräben langsamer als in den breiten Trenchgräben, da mit zunehmenden Aspektverhältnis (Tiefe zu Breite-Verhältnis) ein immer geringerer Teil der aus dem Plasma 28 einfallenden Ionen bis zum Ätzgrund gelangt. Dieser Effekt führt unter anderem zu einer generellen Abnahme der Ätzrate in schmalen Trenchgräben gegenüber breiten, was als "RIE-Lag" bezeichnet wird. Andererseits ist aber auch der Transport von Spezies, beispielsweise polymerbildenden Monomeren, in die Tiefe der Trenchgräben zunehmend schwieriger mit wachsendem Aspektverhältnis, d.h. es erreichen immer weniger polymerbildende Monomere den Ätzgrund, was schließlich zur Folge hat, daß schmale Trenchgräben mit einem dünneren Ätzgrundpolymer belegt werden als breite.

Im erläuterten Beispiel wird daher der ioneninduzierte Abtrag des Ätzgrundpolymers zusätzlich durch eine Veränderung der Substrattemperatur in einem Bereich von -30°C bis +70°C derart eingestellt, daß für alle geätzten Strukturen in dem Siliziumkörper 18, weitgehend unabhängig von deren Aspektverhältnis, nahezu gleiche Ätzraten erreicht werden. Damit wird durch die Einstellung der Temperatur des Siliziumkörpers 18 über die Substratelektrode 12 und die Substratelektrodenkühlung 32 beispielsweise ein annähernd gleichzeitiger Durchbruch des Ätzgrundpolymers im ersten Ätzabschnitt eines jeden Ätzschrittes für alle Strukturbreiten erreicht.

Die günstigste Temperatureinstellung wird dazu bevorzugt in einigen Vorversuchen mittels Testätzungen an Siliziumkörpern, die beispielsweise analog den später im Betrieb der Ätzanlage 5 zu prozessierenden Siliziumkörpern 18 strukturiert sind, unter Einsatz des beschriebenen optischen Emissionsspektrometers 24 oder mittels eines Reflektometers bestimmt. Dies geschieht, indem in den Vorversuchen über das optische Emissionsspektrometer 24 der Durchbruch durch das Ätzgrundpolymer in den Siliziumkörpern 18 über eine Variation der Temperatur des Siliziumkörpers beispielsweise auf einen möglichst steilen Abfall des Fluorsignals oder möglichst steilen Anstieg des Siliziumtetrafluoridsignals hin optimiert wird.

Je geringer die Unterschiede der erforderlichen Durchbruchszeit des Ätzgrundpolymers zwischen unterschiedlich breiten Trenchgräben oder geätzten Strukturen mit unterschiedlichem Aspektverhältnis auf dem Siliziumkörper 18 daher sind, umso steiler erfolgt der Abfall des Fluorsignals im optischen Emissionsspektrometer 24. Damit ist über die Variation der Temperatur des Siliziumkörpers 18 durch die Substratelektrodenkühlung 32 und die Maximierung des Abfalles des Fluorsignals eine Optimierungsstrategie zum Erreichen eines möglichst gleichzeitigen Durchbruchs des Ätzgrundpolymers in unterschiedlichen Strukturen definiert.

Als besonders günstig haben sich Temperaturen von -10°C bis +30°C, bevorzugt +10°C herausgestellt.

Ein viertes, besonders vorteilhaftes Ausführungsbeispiel der Erfindung sieht vor, daß das im ersten Ausführungsbeispiel beschriebene Zurückschalten der Hochfrequenzleistung oder der hochfrequenten Wechselspannung des Hochfrequenzgenerators 14 nach dem Durchbruch des Ätzgrundpolymers, d.h. zu Beginn und während des zweiten Ätzabschnittes in den Ätzschritten dadurch erreicht wird, daß die über den Hochfrequenzgenerator 14 erzeugte, am Siliziumkörper 18 anliegende hochfrequente Wechselspannung oder eingekoppelte Hochfrequenzleistung mit einem zusätzlichen niederfrequenten Modulationsspannungssignal so moduliert wird, daß die sogenannte "Hüllkurve" der hochfrequenten Wechselspannung, d.h. die Verbindungslinie der Wechselspannungsamplituden durch den momentanen Wert der niederfrequenten Modulationsspannung definiert ist. Das niederfrequente Modulationssignal aus einem zusätzlich vorgesehenen, an sich bekannten Niederfrequenzgenerator wird hierzu in einen zur Amplitudenmodulation vorgesehenen Eingang des Hochfrequenzgenerators 14 eingespeist. Viele kommerziell erhältliche Hochfrequenzgeneratoren sind mit einem entsprechenden Modulationseingang ausgestattet, so daß diese Funktion vorteilhaft im Sinne dieser Erfindung genutzt werden kann.

Eine solche Amplitudenmodulation (AM), die sich dann auch entsprechend auf die effektive Ionenbeschleunigungsspannung zwischen Substratelektrode 12 und Plasma 28 überträgt, ist dem Fachmann in der Hochfrequenztechnik an sich bekannt. Im einfachsten Fall erhält man dieses amplitudenmodulierte Hochfrequenzsignal aus einer Multiplikation der hochfrequenten Wechselspannung als Trägerspannung mit dem niederfrequenten Modulationssignal. Die hochfrequente Wechselspannung hat dazu, wie erläutert, beispielsweise eine Frequenz von 1 MHz bis 50 MHz, während die niederfrequente Modulationsspannung eine bevorzugte Frequenz von 50 Hz bis 1 MHz, besonders bevorzugt 200 Hz bis 10 kHz, hat.

Der zeitliche Spannungsverlauf der niederfrequenten Modulationsspannung weist dabei einen rechteckförmigen oder rechteckimpulsförmigen, zumindest abschnittsweise dreieckförmigen oder, bevorzugt, einen zumindest abschnittsweise sinusförmigen Verlauf auf.

Einem rechteckförmigen oder rechteckimpulsförmigen Verlauf der niederfrequenten Modulationsspannung entspricht nach der Multiplikation mit der hochfrequenten Wechselspannung dann ein periodisches Ein- und Ausschalten der vom Hochfrequenzgenerator 14 abgegebenen Hochfrequenzleistung mit der Frequenz der Modulationsspannung. Alternativ verfügen viele kommerziell erhältliche Hochfrequenzgeneratoren über einen speziell zur Modulation mit einem rechteckförmigen Niederfrequenzsignal vorgesehenen Eingang, einen sogenannten "Burst"-Eingang: Solange an diesem "Burst"-Eingang ein oberhalb eines Schwellwerts von beispielsweise 1 V liegender Pegelwert anliegt, wird entsprechend vom Hochfrequenzgenerator 14 eine hochfrequente Wechselspannung oder Hochfrequenzleistung des gewünschten, voreingestellten Sollwertes erzeugt. Bei einem Pegelwert unterhalb dieses Schwellwerts, beispielsweise bei einem Pegelwert 0 V, wird vom Hochfrequenzgenerator 14 keine hochfrequente Wechselspannung oder Hochfrequenzleistung erzeugt. Dieser Steuerung des Hochfrequenzgenerators 14 entspricht ein periodisches Ein- und Ausschalten des Hochfrequenzgenerators 14 mit der Frequenz der niederfrequenten Modulationsspannung.

Der Vorteil eines Burst-Eingangs gegenüber gewöhnlichen Ein- und Ausschaltvorgängen besteht in besonders schnell und reproduzierbar ablaufenden Schaltvorgängen.

Im einzelnen wird im erläuterten Ausführungsbeispiel während eines ersten Ätzabschnittes eines Ätzschrittes, d.h. bis zum Durchbruch des Ätzgrundpolymers, zunächst über den Hochfrequenzgenerator 14 eine hochfrequente Wechselspannung mit konstanter Amplitude d.h. ohne eine zusätzliche Modulation an den Siliziumkörper 18 angelegt. Nach dem Durchbruchs des Ätzgrundpolymers, der analog den vorausgehenden Ausführungsbeispielen beispielsweise mittels des optischen Emissionspektrometers 24 bestimmt wird, und der somit dynamisch die Zeitdauer des ersten Ätzabschnittes bestimmt, wird dann in einem zweiten Ätzabschnitt mit einer reduzierten effektiven Ionenbeschleunigung weitergearbeitet.

Dazu werden in diesem zweiten Ätzabschnitt durch eine entsprechende zusätzlich erzeugte niederfrequente Modulationsspannung, mit der die eigentliche hochfrequente Wechselspannung in an sich bekannter Weise moduliert wird, hochfrequente Schwingungspakete oder Hochfrequenzimpulse mit einer beispielsweise rechteckförmigen, rechteckimpulsförmigen oder abschnittsweise annähernd sinusförmigen Einhüllenden in zeitlichem Abstand periodisch auf die Substratelektrode 12 bzw. den Siliziumkörper 18 gegeben.

Im einfachsten Fall weist die Einhüllende der hochfrequenten Wechselspannungspulse in diesem zweiten Ätzabschnitt einen sinusförmigen Verlauf auf, so daß sich die effektive Ionenbeschleunigungsspannung, auf die sich diese Modulation überträgt, gegenüber dem ersten Ätzabschnitt halbiert.

Eine Absenkung der effektiven Ionenbeschleunigung im zweiten Ätzabschnitt läßt sich zusätzlich oder alternativ durch einen größeren zeitlichen Abstand der hochfrequenten Wechselspannungspulse voneinander oder durch eine zeitliche Verkürzung der Dauer der Wechselspannungspulse erreichen. Entsprechend dem jeweiligen über den zeitlichen Abstand und die zeitliche Dauer der hochfrequenten Wechselspannungspulse definierten "Impuls-Pause-Verhältnis" nimmt dann auch die effektive Ionenbeschleunigungsspannung zur Substratelektrode 12 und damit zum zu ätzenden Siliziumkörper 18 zu oder ab. Typische Impuls-Pause-Verhältnisse liegen zwischen 0,01 bis 1. Besonders bevorzugt sind Impuls-Pause-Verhältnisse zwischen 0,05 und 0,2.

Das erläuterte Verfahren zur Veränderung der effektiven Ionenbeschleunigungsspannung im zweiten Ätzabschnitt mittels einer zusätzlichen, in ihrer Frequenz einstellbaren, relativ niederfrequenten Modulationsspannung sowie einem variabel einstellbaren Impuls-Pause-Verhältnis ist offensichtlich auch zur Einstellung der effektiven Ionenbeschleunigung im ersten Ätzabschnitt geeignet und dort sehr vorteilhaft.

So können beispielsweise unterschiedliche Ionenbeschleunigungsspannungen in den verschiedenen Ätzabschnitten oder Prozeßschritten des erfindungsgemäßen Ätzverfahrens auch dadurch erreicht werden, daß eine zeitlich hinsichtlich ihrer Amplitude unveränderte hochfrequente Wechselspannung oder eingekoppelte Hochfrequenzleistung des Hochfrequenzgenerators 14 verwendet wird, daß diese Wechselspannung oder Hochfrequenzleistung dann aber über die zusätzliche niederfrequente Modulationsspannung zumindest zeitweise mit unterschiedlichen Frequenzen oder Signalformen moduliert wird, oder unterschiedliche Impuls-Pause-Verhältnisse aufweist. Speziell im Fall eines rechteckförmigen Impulsverlauf kann der Hochfrequenzgenerator 14 auf diese Weise unter Verwendung seines "Burst"-Eingangs mit einer niederfrequenten Rechteckspannung mit variablem Impuls-Pause-Verhältnis periodisch ein- und ausgeschaltet ("gepulst") werden. Damit werden Hochfrequenzimpulse mit einer annähernd rechteckförmigen Einhüllenden generiert, die ein einstellbares Impuls-Pause-Verhältnis aufweisen, das bevorzugt deutlich kleiner als 1 ist und insbesondere zwischen 0,2 und 0,01 liegt.

Durch den Einsatz von hochfrequenten Wechselspannungspulsen während des zweiten Ätzabschnittes in den Ätzschritten wird somit der Ätzgrund während der Dauer dieser Pulse immer wieder freigeräumt und auch nur in diesen Phasen ein Vorwärtstreiben des Seitenwandpolymerfilms bewirkt. In der Zeit zwischen zwei Pulsen findet dann zwar eine gewisse (Re-) Deposition auf dem Ätzgrund und auch ein gewisser Seitenwandangriff infolge Fehlens eines Vorwärtssputtereffekts an der Seitenwand, d.h. geringer lokaler Anisotropie, statt, der nächste hochfrequente Wechselspannungspuls räumt den Ätzgrund dann aber wieder frei und gewährleistet auch ein Vorwärtstreiben des Seitenwandfilms weiter in den Trenchgraben hinein.

Da nach dem ersten Entfernen des initialen Polymerfilms am Ätzgrund zu Beginn eines jeden Ätzschrittes im ersten Ätzabschnitt nur noch zufällige Redepositionen vom Ätzgrund zu beseitigen sind, ist ein derartiger Einsatz von nur relativ kurzen, dafür aber jeweils intensiven Wechselspannungspulsen während des zweiten Ätzabschnittes jedoch vielfach ausreichend.

Die Prozeßführung mit einer niederfrequenten Modulation der hochfrequenten Wechselspannung oder Hochfrequenzleistung und/oder einem definiert eingestellten Impuls-Pause-Verhältnis der hochfrequenten Wechselspannungspulse während der einzelnen Ätzabschnitte hat gegenüber den übrigen Ausführungsbeispielen den sehr wesentlichen zusätzlichen Vorteil, daß innerhalb der Pulspausen d.h. keine anliegende Ionenbeschleunigungsspannung oder nur geringen effektiven Ionenbeschleunigungsspannungen in dem Siliziumkörper 18 jeweils eine Entladung von zuvor unvermeidlich induzierten Aufladungen ermöglicht wird.

Besonders bevorzugt zur Vermeidung von induzierten Aufladungen ist dabei die Verwendung möglichst kurzer, intensiver Hochfrequenzimpulse, d.h. kurzer Hochfrequenzimpulse mit hohen Spannungsamplituden und relativ langen Pausen zwischen den einzelnen Hochfrequenzimpulsen. In diesem Fall findet während der kurzen Dauer der intensiven Impulse, die die einfallenden Ionen kurzzeitig auf hohe Ionenenergien beschleunigen, zunächst nur eine geringe Aufladung eines beispielsweise dielektrischen Ätzgrunds statt.

Diese, an sich bereits geringe Aufladung wird dann in den relativ langen Pausen zwischen den einzelnen Hochfrequenzimpulsen weiter zusätzlich über Entladung reduziert, bevor der nächste kurze Hochfrequenzimpulsen mit entsprechend hoher Ionenbeschleunigung folgt. Für eine derartige Modulation mit möglichst kurzen Hochfrequenzimpulsen und langen Pausen zwischen den Pulsen wird bevorzugt eine niederfrequente Wiederholfrequenz von 50 Hz bis 10 kHz eingesetzt.

Im übrigen ist es selbstverständlich möglich, die vorhergehend beschriebene Modulation der hochfrequenten Wechselspannung und die Variation des Impuls-Pause-Verhältnisses miteinander zu kombinieren.

Ein fünftes Ausführungsbeispiel sieht weiter vor, einen zweiten, zusätzlichen Hochfrequenzgenerator einzusetzen, der analog dem Hochfrequenzgenerator 14 aufgebaut ist und ebenfalls mit der Substratelektrode 12 in Verbindung steht, und der im ersten Ätzabschnitt jeweils auf das Signal des Hochfrequenzgenerators 14 aufgeschaltet wird. Dieser zweite zusätzliche Generator wird dabei bevorzugt derart betrieben, daß er dem Signal des Hochfrequenzgenerators 14 kurze Hochfrequenzimpulse mit niedrigen Impuls-Pause-Verhältnis überlagert.

Weiter ist es in diesem Fall vorteilhaft, wenn beide Hochfrequenzgeneratoren auf unterschiedlichen Frequenzen, beispielsweise auf 2 MHz und 13,56 MHz, arbeiten, so daß der Hochfrequenzgenerator 14 durchgehend betrieben wird und der zweite Hochfrequenzgenerator nur während sogenannter "Burst-Phasen" zugeschaltet wird, die beispielsweise dem Durchbruch des Ätzgrundpolymers dienen.

Durch die Verwendung unterschiedlicher Frequenzen für beide Generatoren wird in einfacher Weise eine elektrische Isolation der Generatoren gegeneinander durch zugeordnete, unterschiedlich abgestimmte Anpaßnetzwerke erreicht, und somit eine gegenseitige Leistungseinkopplung der Generatoren ineinander vermieden.

Im übrigen lassen sich die vorstehenden Ausführungsbeispiele auch mit einer zumindest zeitweiligen Zugabe eines chemisch besonders aggressiv gegenüber dem Ätzgrundpolymer wirkenden Gases, beispielsweise O₂ oder bevorzugt NF₃, kombinieren, wobei dieses besonders aggressive Gas mit einem Gasfluß von 2 sccm bis 20 sccm bevorzugt lediglich während des ersten Ätzabschnittes zur Unterstützung eines möglichst schnellen Ätzgrundpolymerdurchbruchs eingesetzt und nach erfolgtem Durchbruch während des zweiten Ätzabschnittes dann nicht mehr dem Prozeßgas zugesetzt wird.

Die vorstehenden Ausführungsbeispiele erläutern das erfindungsgemäße Verfahren am Beispiel der anisotropen Ätzung von Silizium. Das Verfahren ist jedoch nicht auf Silizium beschränkt, sondern eignet sich, teilweise verbunden mit einer dem Fachmann an sich bekannten Anpassung der Prozeßparameter und Reaktivgase, auch für andere Halbleitermaterialien wie beispielsweise Ge, GaAs, AlN, und GaP.

### Bezugszeichenliste

- 5: Plasmaätzanlage
- 10: Ätzkammer
- 12: Substratelektrode
- 14: Hochfrequenzgenerator
- 16: Surfatron
- 18: Siliziumkörper
- 20: Resonator
- 24: optisches Emissionsspektrometer
- 26: Auswerteeinheit
- 28: Plasma
- 30: Kühlaggregat
- 32: Substratelektrodenkühlung

## Patentansprüche

1. Verfahren zum anisotropen Ätzen von Strukturen in einem Halbleiterkörper mit alternierenden Ätz- und Polymerisationsschritten, insbesondere von mit einer Ätzmaske lateral exakt definierten Ausnehmungen in einem Siliziumkörper (18), mittels eines Plasmas (28), wobei an dem Halbleiterkörper zumindest während eines über eine vorgegebene Zeitdauer andauernden Ätzschrittes eine Ionenbeschleunigungsspannung zwischen dem Plasma (28) und dem Halbleiterkörper angelegt wird, wobei die Zeitdauer des Ätzschrittes in mindestens zwei Ätzabschnitte unterteilt wird, zwischen denen die angelegte Ionenbeschleunigungsspannung jeweils verändert wird,
**dadurch gekennzeichnet,**
**dass** die Amplitude einer anliegenden hochfrequenten Wechselspannung oder einer eingekoppelten Hochfrequenzleistung zur Erzeugung der Ionenbeschleunigungsspannung mit einem niederfrequenten Modulationssignal aus einem Niederfrequenzgenerator moduliert, getaktet oder gepulst wird.

2. Verfahren nach Anspruch 1, **dadurch gekennzeichnet, daß** das niederfrequente Modulationssignal eine Frequenz von 50 Hz bis 1 MHz hat und einen rechteckförmigen, rechteckimpulsförmigen, zumindest abschnittsweise dreieckförmigen oder zumindest abschnittsweise sinusförmigen Signalverlauf aufweist.

3. Verfahren nach Anspruch 1, **dadurch gekennzeichnet, daß** das niederfrequente Modulationssignal ein Rechtecksignal oder Rechteckimpulssignal mit einstellbarem, zumindest zwischen den Ätzabschnitten unterschiedlichem Puls-Pause-Verhältnis ist, das die Amplitude der eingekoppelten Hochfrequenzleistung taktet, und das der anliegenden Ionenbeschleunigungsspannung ein entsprechendes Puls-Pause-Verhältnis aufprägt.

4. Verfahren nach Anspruch 3, **dadurch gekennzeichnet, daß** das Puls-Pause-Verhältnis zwischen 0,01 und 1, insbesondere zwischen 0,01 und 0,2 liegt.

5. Verfahren nach einem der Ansprüche 1 bis 4, **dadurch gekennzeichnet, daß** als Halbleiterkörper ein strukturierter Siliziumwafer verwendet wird, der mit einer Substratelektrode (12) in Verbindung steht.

6. Verfahren nach einem der Ansprüche 1 bis 5, **dadurch gekennzeichnet, daß** während des ersten Ätzabschnittes eine höhere hochfrequente Wechselspannung und/oder eine höhere Hochfrequenzleistung verwendet wird, als während des zweiten Ätzabschnittes.

7. Verfahren nach Anspruch 6, **dadurch gekennzeichnet, daß** während des ersten Ätzabschnittes eine hochfrequente Wechselspannung mit einer Amplitude von 20 Volt bis 70 Volt und während des zweiten Ätzabschnittes eine hochfrequente Wechselspannung mit einer Amplitude von 10 Volt bis 20 Volt eingesetzt wird.

8. Verfahren nach einem der Ansprüche 1 bis 7, **dadurch gekennzeichnet, daß** die anliegende Ionenbeschleunigungsspannung während der Passivierschritte abgeschaltet oder zumindest deutlich reduziert wird.

9. Verfahren nach einem der Ansprüche 1 bis 8, **dadurch gekennzeichnet, daß** die Änderung der angelegten Ionenbeschleunigungsspannung zwischen den Ätzabschnitten und/oder den Ätzschritten und den Passivierschritten abrupt oder kontinuierlich unter Einsatz einer zeitlichen Rampenfunktion erfolgt.

10. Verfahren nach einem der Ansprüche 1 bis 9, **dadurch gekennzeichnet, daß** neben der angelegten Ionenbeschleunigungsspannung zwischen den Ätzabschnitten und/oder zwischen den Ätzschritten und den Passivierschritten weiterhin der Prozeßdruck und/oder die Plasmaleistung und/oder der Gasfluß und/oder die Zusammensetzung des eingesetzten Reaktivgases verändert wird.

## Claims

1. Method for anisotropic etching of structures in a semiconductor body with alternate etching and polymerization steps, in particular of cutouts in a silicon body (18) that are exactly defined laterally with an etching mask, by means of a plasma (28), wherein, at the semiconductor body, at least during an etching step lasting for a predetermined time duration, an ion acceleration voltage is applied between the plasma (28) and the semiconductor body, wherein the time duration of the etching step is subdivided into at least two etching sections between which the applied ion acceleration voltage is altered in each case,
**characterized**
**in that** the amplitude of a high-frequency AC voltage present or of a coupled-in high-frequency power for generating the ion acceleration voltage is modulated, clocked or pulsed with a low-frequency modulation signal from a low-frequency generator.

2. Method according to Claim 1, **characterized in that** the low-frequency modulation signal has a frequency of 50 Hz to 1 MHz and has a signal profile with a rectangular waveform, with a rectangular pulse waveform, with a triangular waveform at least in sections or with a sinusoidal waveform at least in sections.

3. Method according to Claim 1, **characterized in that** the low-frequency modulation signal is a rectangular signal or rectangular pulse signal having an adjustable mark-space ratio which differs at least between the etching sections, which clocks the amplitude of the coupled-in high-frequency power, and which impresses a corresponding mark-space ratio on the ion acceleration voltage present.

4. Method according to Claim 3, **characterized in that** the mark-space ratio lies between 0.01 and 1, in particular between 0.01 and 0.2.

5. Method according to one of Claims 1 to 4, **characterized in that** a patterned silicon wafer is used as the semiconductor body, said silicon wafer being connected to a substrate electrode (12).

6. Method according to one of Claims 1 to 5, **characterized in that** a higher high-frequency AC voltage and/or a higher high-frequency power is used during the first etching section than during the second etching section.

7. Method according to Claim 6, **characterized in that** a high-frequency AC voltage having an amplitude of 20 volts to 70 volts is used during the first etching section and a high-frequency AC voltage having an amplitude of 10 volts to 20 volts is used during the second etching section.

8. Method according to one of Claims 1 to 7, **characterized in that** the ion acceleration voltage present is switched off or at least significantly reduced during the passivating steps.

9. Method according to one of Claims 1 to 8, **characterized in that** the change in the applied ion acceleration voltage between the etching steps and/or the etching steps and the passivating steps is effected abruptly or continuously with the use of a temporal ramp function.

10. Method according to one of Claims 1 to 9, **characterized in that** besides the applied ion acceleration voltage between the etching sections and/or between the etching steps and the passivating steps furthermore the process pressure and/or the plasma power and/or the gas flow and/or the composition of the reactive gas used is altered.

## Revendications

1. Procédé de gravure anisotrope de structure dans un semi-conducteur avec des étapes alternées de gravure et de polymérisation notamment de cavités latéralement définies de manière exacte avec un masque de gravure dans un corps en silicium (18) à l'aide de plasma (28),
pendant une étape de gravure, de durée prédéterminée, on applique au semi-conducteur, une tension d'accélération ionique entre le plasma (28) et le semi-conducteur,
la durée de l'étape de gravure étant subdivisée en au moins deux étapes de gravure entre lesquelles on varie chaque fois la tension d'accélération ionique appliquée,
**caractérisé en ce que**
l'amplitude d'une tension alternative haute fréquence appliquée ou d'une puissance haute fréquence injectée pour générer la tension d'accélération ionique est modulée, cadencée ou pulsée par un signal de modulation basse fréquence fourni par un générateur basse fréquence.

2. Procédé selon la revendication 1,
**caractérisé en ce que**
le signal de modulation basse fréquence a une fréquence comprise entre 50 Hz et 1 MHz et une forme de signal impulsionnel rectangulaire, au moins par segment de forme triangulaire ou au moins par segment en forme de signal sinusoïdal.

3. Procédé selon la revendication 1,
**caractérisé en ce que**
le signal de modulation basse fréquence est un signal rectangulaire ou un signal impulsionnel rectangulaire à rapport de travail impulsion/pause, réglable différent au moins entre les segments de gravure, qui commande en cadence l'amplitude de la puissance haute fréquence injectée et induit dans la tension ionique appliquée un rapport correspondant impulsion/pause.

4. Procédé selon la revendication 3,
**caractérisé en ce que**
le rapport impulsion/pause est compris entre 0, 01 et 1, notamment entre 0,01 et 0,2.

5. Procédé selon l'une quelconque des revendications 1 à 4,
**caractérisé en ce que**
le corps semi-conducteur est une plaquette de silicium structurée, reliée à une électrode de substrat (12).

6. Procédé selon l'une quelconque des revendications 1 à 5,
**caractérisé en ce que**
pendant la première étape de gravure, on utilise une tension alternative haute fréquence plus élevée et/ou une puissance haute fréquence plus élevée que dans la seconde étape de gravure.

7. Procédé selon la revendication 6,
**caractérisé en ce que**
pendant la première étape de gravure, on applique une tension alternative haute fréquence avec une amplitude de 20 volts jusqu'à 70 volts et pendant la seconde étape de gravure, on utilise une tension alternative haute fréquence avec une amplitude de 10 volts à 20 volts.

8. Procédé selon l'une quelconque des revendications 1 à 7,
**caractérisé en ce que**
pendant les étapes de passivation, on coupe ou au moins on réduit de manière significative la tension d'accélération ionique appliquée.

9. Procédé selon l'une quelconque des revendications 1 à 8,
**caractérisé en ce que**
la variation de la tension d'accélération ionique appliquée se fait entre les étapes de gravure et/ou entre les étapes de gravure et les étapes de passivation, de manière abrupte ou de façon continue en utilisant une fonction de rampe dans le temps.

10. Procédé selon l'une quelconque des revendications 1 à 9,
**caractérisé en ce qu'**
à côté de la tension d'accélération ionique appliquée, entre les étapes de gravure et/ou entre les étapes de gravure et les étapes de passivation, on modifie en outre la pression du procédé et/ou la puissance de plasma et/ou le flux de gaz et/ou la composition du gaz de réaction utilisé.
